(19) Europäisches Patentamt
European Patent Office
Office européen des brevets

(11) EP 3 702 424 B1

(12) **EUROPEAN PATENT SPECIFICATION**

(45) Date of publication and mention of the grant of the patent:
**28.07.2021 Bulletin 2021/30**

(51) Int Cl.:
***C09G 1/02*** *(2006.01)* ***H01L 21/3105*** *(2006.01)*
***H01L 21/306*** *(2006.01)* ***H01L 21/321*** *(2006.01)*

(21) Application number: **20158719.3**

(22) Date of filing: **21.02.2020**

(54) **SHALLOW TRENCH ISOLATION CHEMICAL AND MECHANICAL POLISHING SLURRY**

CHEMISCHER UND MECHANISCHER POLIERSCHLAMM ZUR ISOLIERUNG VON FLACHEN GRÄBEN

BOUE DE POLISSAGE CHIMIQUE ET MÉCANIQUE POUR L'ISOLATION DE TRANCHÉES PEU PROFONDES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.02.2019 US 201962810722 P**
**22.01.2020 US 202016749625**

(43) Date of publication of application:
**02.09.2020 Bulletin 2020/36**

(73) Proprietor: **Versum Materials US, LLC**
**Tempe, AZ 85284 (US)**

(72) Inventors:
- **ROSE, Joseph D**
  **Tempe, AZ 85284 (US)**
- **SHI, Xiaobo**
  **Tempe, AZ 85284 (US)**
- **ZHOU, Hongjun**
  **Tempe, AZ 85284 (US)**
- **MURELLA, Krishna P.**
  **Tempe, AZ 85284 (US)**

(74) Representative: **Beck Greener LLP**
**Fulwood House**
**12 Fulwood Place**
**London WC1V 6HR (GB)**

(56) References cited:
**WO-A1-03/101665** **WO-A1-2015/053982**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

BACKGROUND OF THE INVENTION

This invention relates to Shallow Trench Isolation (STI) chemical mechanical planarization (CMP) compositions and chemical mechanical planarization methods (CMP) for Shallow Trench Isolation (STI) process.

In the fabrication of microelectronics devices, an important step involved is polishing, especially surfaces for chemical-mechanical polishing for recovering a selected material and/or planarizing the structure.

For example, a SiN layer is deposited under a $SiO_2$ layer to serve as a polish stop layer. The role of such polish stop is particularly important in Shallow Trench Isolation (STI) structures. Selectivity is characteristically expressed as the ratio of the silicon dioxide (silicon oxide for short) polish rate to the nitride polish rate. An example is an increased polishing selectivity rate of silicon dioxide ($SiO_2$) as compared to silicon nitride (SiN).

In the global planarization of patterned STI structures, reducing SiN film removal rates and reducing oxide trench dishing are two key factors to be considered. The lower trench oxide loss will prevent electrical current leaking between adjacent transistors. Non-uniform trench oxide loss across die (within Die) will affect transistor performance and device fabrication yields. Severe trench oxide loss (high oxide trench dishing) will cause poor isolation of transistor resulting in device failure. Therefore, it is important to reduce trench oxide loss by reducing oxide trench dishing in STI CMP polishing compositions.

US Patent 5,876,490 discloses the polishing compositions containing abrasive particles and exhibiting normal stress effects. The slurry further contains non-polishing particles resulting in reduced polishing rate at recesses, while the abrasive particles maintain high polish rates at elevations. This leads to improved planarization. More specifically, the slurry comprises cerium oxide particles and polymeric electrolyte, and can be used for Shallow Trench Isolation (STI) polishing applications.

US Patent 6,964,923 teaches the polishing compositions containing cerium oxide particles and polymeric electrolyte for Shallow Trench Isolation (STI) polishing applications. Polymeric electrolyte being used includes the salts of polyacrylic acid, similar to those in US Patent 5,876,490. Ceria, alumina, silica & zirconia are used as abrasives. Molecular weight for such listed polyelectrolyte is from 300 to 20,000, but in overall, <100,000.

US Patent 6,616,514 discloses a chemical mechanical polishing slurry for use in removing a first substance from a surface of an article in preference to silicon nitride by chemical mechanical polishing. The chemical mechanical polishing slurry according to the invention includes an abrasive, an aqueous medium, and an organic polyol that does not dissociate protons, said organic polyol including a compound having at least three hydroxyl groups that are not dissociable in the aqueous medium, or a polymer formed from at least one monomer having at least three hydroxyl groups that are not dissociable in the aqueous medium.

US Patent 6,984,588 discloses a chemical mechanical polishing composition comprising a soluble cerium compound at a pH above 3 and a method to selectively polish a silicon oxide overfill in preference to a silicon nitride film layer in a single step during the manufacture of integrated circuits and semiconductors.

US Patent 6,544,892 discloses a method of removing silicon dioxide in preference to silicon nitride from a surface of an article by chemical-mechanical polishing comprising polishing said surface using a polishing pad, water, abrasive particles, and an organic compound having both a carboxylic acid functional group and a second functional group selected from amines and halides.

US Patent 7,247,082 discloses a polishing composition comprising an abrasive, a pH adjusting agent, an improver of a selective ratio, and water, wherein the abrasive is contained in an amount of from 0.5 to 30% by weight, the pH adjusting agent is contained in an amount of from 0.01 to 3% by weight, the improver of a selective ratio is contained in an amount of 0.3 to 30% by weight, and water is contained in an amount of 45 to 99.49% by weight, wherein the weight % is based on the weight of the polishing composition, and wherein the improver is one or more compounds selected from the group consisting of methylamine, ethylamine, propylamine, isopropyl amine, dimethylamine, diethylamine, dipropylamine, diisopropylamine, ethylenediamine, 1,2-diaminopropane, 1,3-propanediamine, 1,4-butanediamine, hexamethylenediamine, N,N,N',N'-tetramethyl-1,6-diaminohexane, 6-(dimethylamino)-1-hexanol, bis(3-aminopropyl)amine, triethylenetetraamine, diethylene glycol bis(3-aminopropyl) ether, piperazine, and piperidine.

US Patent 8,778,203 discloses a method for selectively removing a target material on a surface of a substrate, the method comprising the steps of: providing a substrate comprising a target material and a non-target material; dissolving oxygen in a polishing solution to achieve a pre-determined dissolved oxygen concentration, the polishing solution having a pH of from about 5 to about 11, wherein the polishing solution comprises a plurality of abrasive silica particles, at least some of said plurality of abrasive silica particles are functionalized with n-(trimethoxysilylpropyl)isothiouronium chloride; maintaining, by continuously applying substantially pure oxygen to said polishing solution, the pre-determined dissolved oxygen concentration of said polishing solution at or between approximately 8.6 mg/L and approximately 16.6 mg/L; disposing the polishing solution between a polishing pad and the surface; applying the polishing pad to the surface; and selectively removing a predetermined thickness of the target material; wherein varying the dissolved oxygen content

of the polishing solution varies the removal ratio of target material to non-target material during the removal step.

US Patent 6,914,001 discloses a chemical mechanical polishing method comprising: contacting a surface of a semiconductor wafer with a surface of a polishing pad; supplying an aqueous solution containing abrasive particles, a removal rate accelerator, and different first and second passivation agents to an interface between the surface of the polishing pad and the surface of the semiconductor wafer, wherein the first passivation agent is an anionic, cationic or nonionic surfactant; and, rotating the surface of the semiconductor wafer relative to the surface of the polishing pad to remove an oxide material on the semiconductor wafer.

WO 03/101665 A1 discloses an aqueous chemical mechanical polishing composition which is selective for silica vs silicon nitride, comprising ceria abrasive particles and an organic polyol.

However, those prior disclosed Shallow Trench Isolation (STI) polishing compositions did not address the importance of suppressing SiN film removal rate and reducing oxide trench dishing and more uniform oxide trench dishing on the polished patterned wafers along with the high oxide vs nitride selectivity. Also, those prior disclosed Shallow Trench Isolation (STI) polishing compositions did not provide suitable methods for how to use blanket wafer polishing results to predict patterned wafer polishing performances.

Therefore, it should be readily apparent from the foregoing that there remains a need within the art for compositions, methods and systems of STI chemical mechanical polishing that can afford the reduced SiN film removal rates and the reduced oxide trench dishing and more uniform oxide trench dishing across various sized oxide trench features on polishing patterned wafers in a STI chemical and mechanical polishing (CMP) process, and that can afford a method for using blanket wafer polishing results to predict patterned wafer polishing performances in addition to high removal rate of silicon dioxide as well as high selectivity for silicon dioxide to silicon nitride.

## Summary of The Invention

The present invention provides STI CMP polishing slurries or compositions for suppressed SiN film removal rate and high TEOS: SiN selectivity and reduced oxide trench dishing on the polished patterned wafers. In addition, in preferred embodiments the compositions improve oxide to nitride selectivity by metric for better predicting patterned performance from blanket results.

The present invented STI CMP polishing compositions preferably provide high oxide vs nitride selectivity by introducing chemical additives as SiN film removal rate suppressing agents and oxide trenching dishing reducers in the Chemical mechanical polishing (CMP) compositions for Shallow Trench Isolation (STI) CMP applications at wide pH range including acidic, neutral and alkaline pH conditions.

The disclosed chemical mechanical polishing (CMP) compositions for Shallow Trench Isolation (STI) CMP applications have a unique combination of using ceria-coated inorganic oxide abrasive particles and suitable chemical additives as oxide trench dishing reducing agents and nitride suppressing agents.

The present invention also provides methods and systems used to polish SiN film at high down force and polish silicon oxide film at relatively low-down force which still afford the desirable silicon oxide film removal rates for actual STI CMP process applications. The methods and systems have been proved to be an effective way to use blanket wafer polishing results to predict the patterned wafer polishing performances while suitable chemical additives were used as SiN removal rate suppressing agents.

In one aspect, there is provided a STI CMP polishing composition which comprises:

ceria-coated inorganic oxide particles;
two chemical additives independently selected from two different groups: non-ionic organic surfactant molecules including polysorbate-type surfactants formed by the ethoxylation of the sorbitan and non-ionic organic molecules with multi hydroxyl functional groups in the same molecule;
a water-soluble solvent; and
optionally
biocide; and
pH adjuster;
wherein the composition has a pH of 2 to 12, preferably 3 to 10, more preferably 4 to 9, and most preferably 4.5 to 7.5.

The ceria-coated inorganic oxide particles include, but are not limited to, ceria-coated colloidal silica, ceria-coated alumina, ceria-coated titania, ceria-coated zirconia, or any other ceria-coated inorganic oxide particles.

The water-soluble solvent includes but is not limited to deionized (DI) water, distilled water, and alcoholic organic solvents.

The chemical additives preferably function as a SiN film removal rate suppressing agent and oxide trenching dishing reducer.

The first group of chemical additives are non-ionic organic surfactant molecules including polysorbate-type

surfactants formed by the ethoxylation of the sorbitan.

Some examples of the first group chemical additives include, but are not limited to: polyoxyethylenesorbitan monolaurate, polyoxyethylenesorbitan monopalmitate, polyoxyethylene sorbitan monostearate, polyoxyethylenesorbitan tristearate, Polyoxyethylenesorbitan monooleate, polyoxyethylenesorbitan trioleate and others.

The second group of chemical additives are non-ionic organic molecules with multi hydroxyl functional groups in the same molecule.

The second group of chemical additives includes, but is not limited to, non-ionic organic molecules having the following structures.

In one embodiment, the chemical additive of the second group has a general structure (a) as shown below:

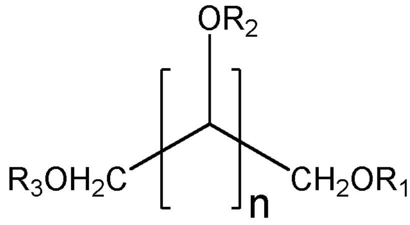

(a).

wherein n is selected from 2 to 5,000, preferably from 3 to 12, and more preferably from 4 to 6.

$R_1$, $R_2$, and $R_3$ groups can be the same or different atoms or functional groups.

$R_1$, $R_2$, and $R_3$ can be independently selected from the group consisting of hydrogen, an alkyl group $C_mH_{2m+1}$, wherein m is from 1 to 12, preferably 1 to 6, and more preferably 1 to 3; alkoxy; an organic group with one or more hydroxyl groups; optionally substituted organic sulfonic acid; optionally substituted organic sulfonic acid salt; optionally substituted organic carboxylic acid; optionally substituted organic carboxylic acid salt; organic carboxylic ester; organic amine groups; and combinations thereof; wherein at least two or more of $R_{1-3}$ groups are hydrogen atoms.

In another embodiment, the chemical additive of the second group has a general structure as shown below:

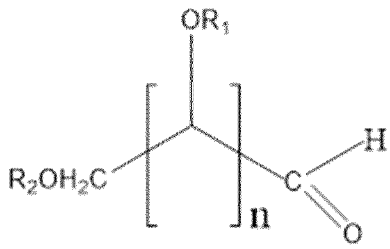

(b).

In this structure, one -CHO functional group is located at one end of the molecule as the terminal functional group; n is selected from 2 to 5,000, preferably from 3 to 12, more preferably from 4 to 7.

Each of $R_1$ and $R_2$ can be independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine groups, and combinations thereof.

In yet another embodiment, the chemical additive of the second group has a molecular structure selected from the group comprising of (c), (d), (e) and combinations thereof:

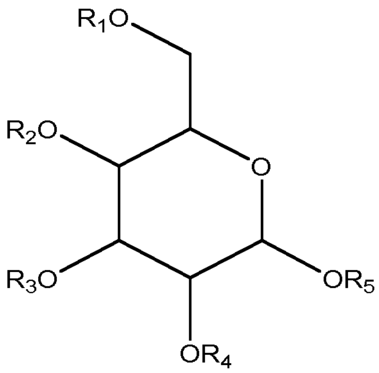

(c),

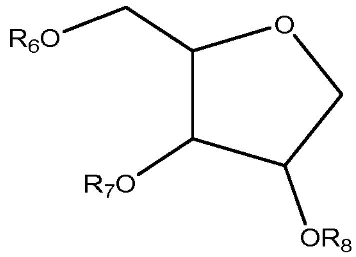

(d),

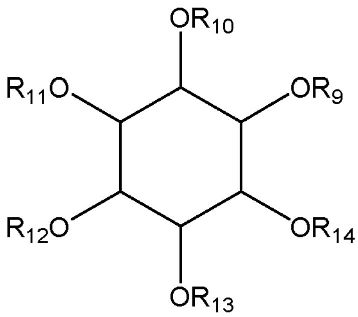

(e).

In these general molecular structures; $R_1$, $R_2$, $R_3$, $R_4$, $R_5$, $R_6$, $R_7$, $R_8$, $R_9$, $R_{10}$, $R_{11}$, $R_{12}$, $R_{13}$, and $R_{14}$ can be the same or different atoms or functional groups.

Each of the $R_{1-14}$ groups can be independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine groups, and combinations thereof; wherein, at least two or more of the $R_{1-14}$ groups in each structure are hydrogen atoms.

For structures (c) and (e), preferably four or more of $R_{1-5}$ and $R_{9-14}$ groups in each structure are hydrogen atoms.

Yet, in another embodiment, the chemical additive of the second group has a general molecular structure (f):

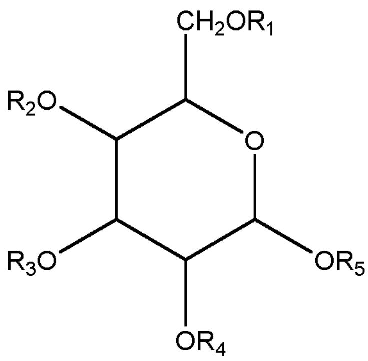

(f).

In the general molecular structure (f), at least two, or at least four, of $R_1$ to $R_5$ are hydrogen atoms. Thus, the chemical additive (f) contains at least two, or at least four, hydroxyl functional groups in the molecular structure.

In structure (f), at least one of $R_1$ to $R_5$ in the general molecular structure (f) is a polyol molecular unit having a structure shown in (i):

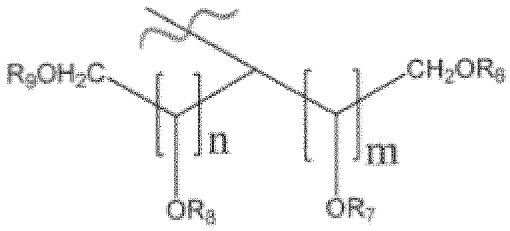

(i),

wherein n and m can be the same or different. m and n re each independently selected from 1 to 5, preferably from 1 to 4, more preferably from 1 to 3, and most preferably from 1 to 2.

$R_6$ to $R_9$ can be the same or different atoms or functional groups; each of $R_6$, $R_7$, $R_8$, and $R_9$ is independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine, and combinations thereof, and at least two of $R_{6-9}$ are hydrogen atoms.

Each of the rest of $R_1$ to $R_5$ in (f) can be independently selected from the group consisting of hydrogen, alkyl, alkoxy, organic group with one or more hydroxyl groups, optionally substituted organic sulfonic acid or salt, optionally substituted organic carboxylic acid or salt, organic carboxylic ester, organic amine, and a six-member ring polyol having a structure shown in (ii):

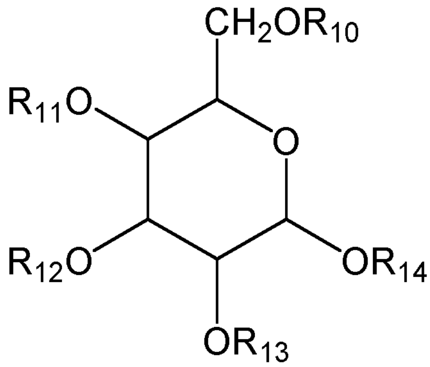

(ii);

wherein the structure (ii) is connected through an oxygen-carbon bond to structure (f) by removing one R from $R_{11}$ to $R_{14}$ in (ii) and each of the rest of $R_{10}$ to $R_{14}$ is independently selected from the group consisting of hydrogen, alkyl, alkoxy, organic group with one or more hydroxyl groups, optionally substituted organic sulfonic acid or salt, optionally substituted organic carboxylic acid or salt, organic carboxylic ester, organic amine, and combinations thereof.

Examples of the second group of chemical additives comprise maltitol, lactitol, maltotritol, ribitol, D-sorbitol, mannitol, dulcitol, iditol, D-(-)-Fructose, sorbitan, sucrose, ribose, Inositol, glucose, D-arabinose, L-arabinose, D-mannose, L-mannose, meso-erythritol, beta-lactose, arabinose, and combinations thereof. The preferred chemical additives are maltitol, lactitol, maltotritol, D-sorbitol, mannitol, dulcitol, iditol, D- (-)-Fructose, sucrose, ribose, Inositol, glucose. D-(+)-mannose, beta-lactose, and combinations thereof. The more preferred chemical additives are maltitol, lactitol, maltotritol, D-sorbitol, mannitol, dulcitol, D- (-)-Fructose, beta-lactose, and combinations thereof.

The molecular structures of some examples of the second group of chemical additives are listed below:

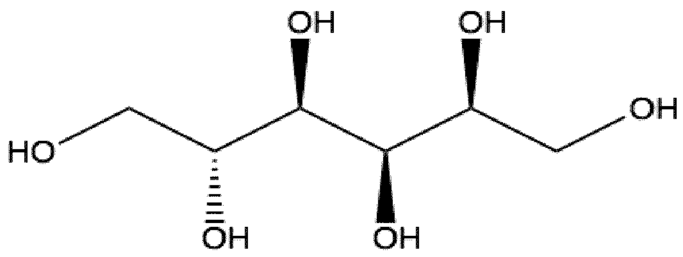

D-sorbitol;

and

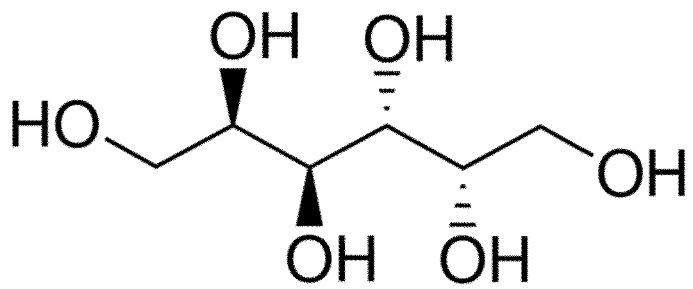

Dulcitol.

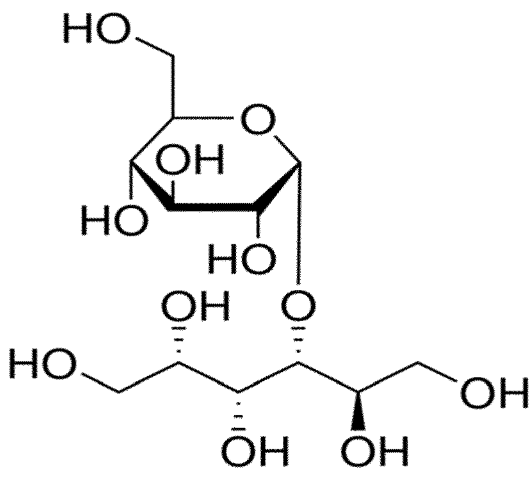

Maltitol,

and

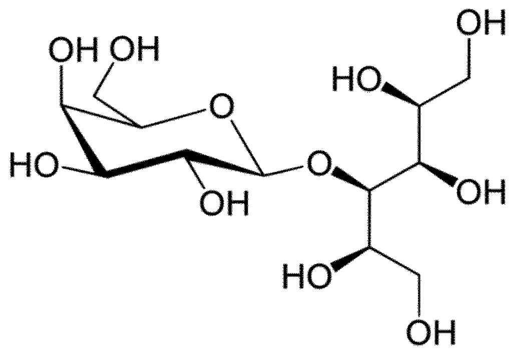

Lactitol.

In another aspect, there is provided a method of chemical mechanical polishing (CMP) a substrate having at least one surface comprising silicon dioxide using the chemical mechanical polishing (CMP) composition described above in Shallow Trench Isolation (STI) process.

In another aspect, there is provided a system of chemical mechanical polishing (CMP) a substrate having at least one surface comprising silicon dioxide using the chemical mechanical polishing (CMP) composition described above in Shallow Trench Isolation (STI) process.

The polished silicon oxide films can be Chemical vapor deposition (CVD), Plasma Enhanced CVD (PECVD), High Density Deposition CVD(HDP), or spin on silicon oxide films.

The substrate disclosed above can further comprises a silicon nitride surface. The removal selectivity of $SiO_2$: SiN is greater than 30, preferably greater than 50, and more preferably greater than 70.

There is also described herein a method of predicting patterned wafer polishing performance of a chemical mechanical polishing composition, comprising

determining down force Down Force 1 (DF1) (psi) for obtaining 2000 Å/min. oxide blanket wafer removal rate using the CMP composition;

determining silicon nitride blanket wafer removal rate at a down force of DF1 + 3.0 psi (20.7 kPa) using the CMP composition;

calculating a DF Offset Selectivity of oxide: silicon nitride films;

selecting the chemical additives having DF Offset Selectivity ≥25, preferably ≥35 or more preferably ≥45;

wherein the DF Offset Selectivity = 2000 Å/min. / SiN Removal Rate (RR) (Å/min) at DF1+3psi (20.7 kPa).

Features described in connection with one aspect of the invention may be used in combination with other aspects of the invention.

## DETAILED DESCRIPTION OF THE INVENTION

In the global planarization of patterned STI structures, suppressing SiN removal rates and reducing oxide trench dishing across various sized oxide trench features are key factors to be considered.

The lower trench oxide loss will prevent electrical current leaking between adjacent transistors. Non-uniform trench oxide loss across die (within Die) will affect transistor performance and device fabrication yields. Severe trench oxide loss (high oxide trench dishing) will cause poor isolation of transistor resulting in device failure. Therefore, it is important to reduce trench oxide loss by reducing oxide trench dishing in STI CMP polishing compositions.

This invention relates to the Chemical mechanical polishing (CMP) compositions for Shallow Trench Isolation (STI) CMP applications.

More specifically, the disclosed chemical mechanical polishing (CMP) composition for Shallow Trench Isolation (STI) CMP applications have a unique combination of using ceria-coated inorganic oxide abrasive particles and the suitable two groups of chemical additives as oxide trench dishing reducing agents and nitride removal rate suppressing agents.

The first group of chemical additives are non-ionic organic surfactant molecules including polysorbate-type surfactants formed by the ethoxylation of the sorbitan, etc.

The ethoxylate unit repeating numbers in the first group additives can be varied which will provide different HLB values and different solubility in deionized water.

Depending on the lengths of the repeating ethoxylate units, Tween® type of the organic surfactants provided by Millipore Sigma are considered and used as first group of chemical additives.

The second group of chemical additives include but are not limited to the organic molecules which bearing multi hydroxyl functional groups on the same molecules.

The second group of chemical additives are non-ionic molecules which bearing two or more hydroxyl functional groups in the same molecules.

The use of both chemical additives in the STI CMP polishing compositions preferably provides the benefits of high silicon oxide film removal rates, low SiN film removal rates, high and tunable Silicon oxide: SiN selectivity, and reduced oxide trench dishing and improved over polishing window stability on polishing patterned wafers.

The particle sizes of the ceria-coated inorganic oxide particles in the disclosed invention herein are suitably ranged from 10nm to 1,000nm, the preferred mean particle sizes are ranged from 20nm to 500nm, the more preferred mean particle sizes are ranged from 50nm to 250nm.

The concentrations of these ceria-coated inorganic oxide particles suitably range from 0.01 wt.% to 20 wt.%, the preferred concentrations range from 0.05 wt.% to 10 wt.%, the more preferred concentrations range from 0.1 wt.% to 5 wt.%.

The preferred ceria-coated inorganic oxide particles are ceria-coated colloidal silica particles.

The preferred water-soluble solvent is DI water.

The STI CMP composition may contain biocide ranging from 0.0001 wt.% to 0.05 wt.%; preferably from 0.0005 wt.% to 0.025 wt.%, and more preferably from 0.001 wt.% to 0.01 wt.%.

The biocide may be, but is not limited to, Kathon™, Kathon™ CG/ICP II, from Dupont/Dow Chemical Co. Bioban from Dupont/Dow Chemical Co. They have active ingredients of 5-chloro-2-methyl-4-isothiazolin-3-one and 2-methyl-4-isothiazolin-3-one.

The STI CMP composition suitably contains 0 wt.% to 1 wt.%; preferably 0.01 wt.% to 0.5 wt.%; more preferably 0.1 wt.% to 0.25 wt.% pH adjusting agent.

An acidic or basic pH adjusting agent can be used to adjust the STI polishing compositions to the optimized pH value.

The pH adjusting agents include, but are not limited to nitric acid, hydrochloric acid, sulfuric acid, phosphoric acid, other inorganic or organic acids, and mixtures thereof.

pH adjusting agents also include basic pH adjusting agents, such as sodium hydride, potassium hydroxide, ammonium hydroxide, tetraalkyl ammonium hydroxide, organic quaternary ammonium hydroxide compounds, organic amines, and other chemical reagents that can be used to adjust pH towards the more alkaline direction.

Depending on the lengths of the repeating ethoxylate units, the first group of chemical additives includes but is not limited to: polyoxyethylenesorbitan monolaurate, polyoxyethylenesorbitan monopalmitate, polyoxyethylene sorbitan monostearate, polyoxyethylenesorbitan tristearate, Polyoxyethylenesorbitan monooleate, polyoxyethylenesorbitan trioleate and others.

The ethoxylate unit repeating numbers in the first group additives can be varied which will provide different HLB values and different solubility in deionized water.

Tween® type of the organic surfactants provided by Millipore Sigma; such as Tween® 20 (Polyoxyethylene sorbitan monolaurate), Tween® 40 (Polyoxyethylene sorbitan monopalmitate), Tween® 60 (Polyoxyethylene sorbitan monostearate), Tween® 65(polyoxyethylenesorbitan tristearate), Tween® 80 (Polyoxyethylene sorbitan monooleate), and Tween® 85(polyoxyethylenesorbitan trioleate) are considered and used as first chemical additives in the STI CMP polishing compositions.

The preferred chemical additives of the second group contain at least two or more hydroxyl groups in the same non-ionic organic molecules.

The STI CMP composition suitably contains 0.001 wt.% to 2.0% wt.%, preferably 0.0025 wt.% to 1.0 wt.%, and more preferable 0.05 wt.% to 0.5 wt.% of the second group of chemical additives.

Silicon oxide to silicon nitride blanket wafer removal rate selectivity is an important screening criterion for selecting a chemical and mechanical polishing (CMP) slurry for Shallow Trench Isolation (STI) application. Blanket wafer selectivity is typically defined as Silicon oxide RR / Silicon nitride (SiN) RR at the same Down Force (DF).

However, good blanket wafer selectivity does not always guarantee desired pattern wafer performance. For example, during pattern wafer polish, as topography changes during over-polish due to dishing, the exposed SiN areas may experience higher DF than the polishing pressure due to localized pressure change.

Thus, if a CMP polishing composition is used having a chemical additive that suppresses SiN blanket wafer RR at a DF higher than the applied polishing pressure for polishing patterned wafer, a good polishing pattern performance can be achieved. Meanwhile, the CMP polishing composition must also maintain high silicon oxide RR in addition to suppressing SiN RR.

A down force (DF) Offset blanket wafer Selectivity method has been developed and applied to predict polishing performances on polishing patterned wafers.

In the present invention, chemical additives are screened for ability to suppress silicon nitride (SiN) blanket wafer RR at a higher DF than would be used in actual STI CMP process, i.e., pattern wafer polishing.

In general, there is always a given silicon oxide film removal rate target with the specific selected and used consumable parts, such as polishing pad and conditioning disk and under the selected polishing recipe setup, such as

applied down force, table/head rotating speeds, slurry flow rate (mL/min.) etc.

In current application, a DF called DF1 to achieve 2,000 Å/min silicon oxide RR is first determined from a testing procedure. This 2,000 Å/min removal rate is a typical RR required for many STI applications.

Next, SiN RR at 3.0 psi (20.7 kPa) higher than DF1 is measured.

A "DF Offset Selectivity" is defined as

$$\text{DF Offset Selectivity} = 2000\ \text{Å/min./ SiN RR (Å/min) at DF1+3psi (20.7 kPa).}$$

By this metric, Tween® chemical additives have shown the best selectivity by maintaining the desired silicon oxide RR at a reasonable DF and showing the greatest SiN RR suppression at an even higher DF, of all slurries tested.

The following non-limiting examples are presented to further illustrate the present invention.

CMP Methodology

In the examples presented below, CMP experiments were run using the procedures and experimental conditions given below.

GLOSSARY

COMPONENTS

Ceria-coated Silica: used as abrasive having a particle size of approximately 100 nanometers (nm); such ceria-coated silica particles can have a particle size of range from approximately 20 nanometers (nm) to 500 nanometers (nm);

Ceria-coated Silica particles (with varied sizes) were supplied by JGC Inc. in Japan.

Chemical additives, such as different Tween® type organic surfactants were supplied by Millipore Sigma, St. Louis, MO; while maltitol, D-Fructose, Dulcitol, D-sorbitol and other chemical raw materials were also supplied by Millipore Sigma-Aldrich, St. Louis, MO.

TEOS: tetraethyl orthosilicate

Polishing Pad: Polishing pad, IK4250UH, IC1010-R32 and other pads were used during CMP, supplied by DOW, Inc.

Conditioning Disk: 3M A122 Disk was used which was provided by 3M company.

PARAMETERS

General

Å or A: angstrom(s) - a unit of length
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch
PS: platen rotational speed of polishing tool, in rpm (revolution(s) per minute)
SF: composition flow, ml/min
Wt. %: weight percentage (of a listed component)
TEOS: SiN Selectivity: (removal rate of TEOS)/ (removal rate of SiN)
HDP: high density plasma deposited TEOS
TEOS or HDP Removal Rates: Measured TEOS or HDP removal rate at a given down pressure. The down pressure of the CMP tool was 1.0, 2.0 or 3.0 psi (6.9, 13.8 or 20.7 kPa) in the examples listed.
SiN Removal Rates: Measured SiN removal rate at a given down pressure. The down pressure of the CMP tool was 3.0, 4.0, or 5.0 psi (20.7, 27.6, 34.5 kPa) in the examples listed.

Metrology

Films were measured with a ResMap CDE, model 168, manufactured by Creative Design Engineering, Inc, 20565 Alves Dr., Cupertino, CA, 95014. The ResMap tool is a four-point probe sheet resistance tool. Forty-nine-point diameter scan at 5mm edge exclusion for film was taken.

CMP Tool

The CMP tool that was used is a 200mm Mirra, or 300mm Reflexion manufactured by Applied Materials, 3050 Boweres Avenue, Santa Clara, California, 95054. An IC1000 pad supplied by DOW, Inc, 451 Bellevue Rd., Newark, DE 19713 was used on platen 1 for blanket and pattern wafer studies.

The IK4250UH pad or other pad was broken in by conditioning the pad for 18 mins at 7 psi (48.3 kPa) down force on the conditioner. To qualify the tool settings and the pad break-in two tungsten monitors and two TEOS monitors were polished with Versum® STI2305 composition, supplied by Versum Materials Inc. at baseline conditions.

Wafers

Polishing experiments were conducted using PECVD or LPCVD or HD TEOS wafers. These blanket wafers were purchased from Silicon Valley Microelectronics, 2985 Kifer Rd., Santa Clara, CA 95051.

Polishing Experiments

In blanket wafer studies, silicon oxide blanket wafers, and SiN blanket wafers were polished at baseline conditions. The tool baseline conditions were: table speed; 87 rpm, head speed: 93 rpm, membrane pressure; 1.0 psi, 2.0 psi, 3.0 psi, 4.0 psi or 5.0 psi (6.9, 13.8, 20.7, 27.6 or 34.5 kPa) DF, composition flow; 200 ml/min. The polishing pad used for testing was IK4250UH or IC1010-R32 pad which was supplied by Dow Chemicals.

Deionized water was used as the solvent in the compositions in the working examples.

The patterned wafers (MIT860), supplied by SWK Associates, Inc. 2920 Scott Blvd. Santa Clara, CA 95054). These wafers were measured on the Veeco VX300 profiler/AFM instrument. The 3 different sized pitch structures were used for silicon oxide dishing measurement. The wafer was measured at center, middle, and edge die positions.

TEOS: SiN or HDP: SiN Selectivity: (removal rate of TEOS) or HDP/ (removal rate of SiN) obtained from the STI CMP polishing compositions were tunable.

**Working Examples**

In the following working examples, a STI polishing composition comprising 0.2 wt.% cerium-coated silica particles, 0.28 wt.% maltitol, a biocide ranging from 0.0001 wt.% to 0.05 wt.%, and deionized water at pH 5.35 was prepared as reference(ref.) 1. There was no first group of additive used in Ref. 1.

A STI polishing composition comprising 0.2 wt.% cerium-coated silica particles, 0.025 wt.% Tween® 20, a biocide ranging from 0.001 wt.% to 0.01 wt.%, and deionized water at pH 5.35 was prepared as reference(ref.) 2. There was no second group additive used in Ref. 2.

The working polishing compositions (or working samples) were prepared with reference 1 (0.2 wt.% cerium-coated silica, 0.28 wt.% maltitol, a biocide ranging from 0.0001 wt.% to 0.05 wt.%, and deionized water) and adding a first group additive such as Tween® type surfactants or other reference non-ionic or anionic organic surfactants or molecules in the concentration range of 0.01 wt.% to 0.025% wt.%. All working polishing compositions were made with pH 5.35.

Other chemical additives being tested included: Polyether Polyol (Tergitol™ L-64 purchased from Dow Chemical.), silicone glycol copolymer surfactant (DABCO® DC 5604 purchased from Evonik Industries.), Octylphenoxypolyethoxyethanol (Nonidet™ P40 Substitute purchased from MilliporeSigma), and polyethylene glycol (PEG) with different molecular weights purchased from MilliporeSigma.

**Example 1**

In Example 1, the polishing compositions used for silicon oxide polishing were shown in Table 1.

The polishing step conditions used were: Dow's IK4250UH pad at 5 different psi DF with table/head speed at 87/93rpm and ex-situ conditioning. Tween® 20 at 0.025 wt.% was used as only additive in Ref.2.

All other non-ionic or anionic surfactants or organic molecular additives were used in the concentration range of 0.01 wt.% to 0.025% wt.%.

All reference samples and working samples had the same pH values at around 5.35.

The removal rates (RR at Å/min) for different films were tested at different down forces.

The effects of different chemical additives on the film removal rates and HDP: SiN film selectivity were observed and listed in Table 1.

As the results show in Table 1, the addition of a chemical additive (one of them was the first group additive Tween® 20) into the polishing compositions of the reference 1, in general, reduced the silicon oxide film removal rates except when used PEG with MW 400.

With Ref. 2 (there was no second group additive used in Ref. 2), the lowest HDP film removal rate and HDP: SiN selectivity were obtained among all tested references and working samples.

Several chemical compositions having additives (such additives included DABCO DC5604 Tween® 20 , Nonidet P40 Substitute, and PEG with 8,000 molecular weight) gave suppressed SiN film removal rates at three applied down forces, while afforded good silicon oxide film removal rates.

Table 1. Effects of Chemical Additives on Film RR (Å /min.) & HDP: SiN Selectivity

| Compositions | DF(psi) | HDP RR (Å/min.) | PECND SiN RR (Å/min.) | HDP@3.0psi (20.7 kPa): SiN@5psi (34.5 kPa) Selectivity |
|---|---|---|---|---|
| 0.2% Ceria-coated Silica + 0.28% Maltitol as Ref. 1 | 3 (20.7 kPa) | 4604 | 57 | |
| | 4 (27.6 kPa) | | 89 | |
| | 5 (34.5 kPa) | | 187 | 25:1 |
| 0.2% Ceria-coated Silica + 0.025% Tween® 20 as Ref. 2 | 3 (20.7 kPa) | 1541 | 53 | |
| | 4 (27.6 kPa) | | 81 | |
| | 5 (34.5 kPa) | | 258 | 6:1 |
| Ref. 1 + 0.025% Tergitol L-64 | 3 (20.7 kPa) | 4085 | 59 | |
| | 4 (27.6 kPa) | | 77 | |
| | 5 (34.5 kPa) | | 120 | 34:1 |
| Ref. 1 + 0.025% DABCO DC5604 | 3 (20.7 kPa) | 4021 | 42 | |
| | 4 (27.6 kPa) | | 64 | |
| | 5 (34.5 kPa) | | 97 | 41:1 |
| Ref. 1 + 0.025% Tween® 20 | 3 (20.7 kPa) | 2929 | 35 | |
| | 4 (27.6 kPa) | | 46 | |
| | 5 (34.5 kPa) | | 53 | 55:1 |

(continued)

| Compositions | DF(psi) | HDP RR (Å/min.) | PECND SiN RR (Å/min.) | HDP@3.0psi (20.7 kPa): SiN@5psi (34.5 kPa) Selectivity |
|---|---|---|---|---|
| Ref. 1 + 0.02% Nonidit P40 Substitute | 3 (20.7 kPa) | 3557 | 43 | |
| | 4 (27.6 kPa) | | 64 | |
| | 5 (34.5 kPa) | | 123 | 29:1 |
| Ref. 1 + 0.015% PEG (MW 8000) | 3 (20.7 kPa) | 2584 | 52 | |
| | 4 (27.6 kPa) | | 62 | |
| | 5 (34.5 kPa) | | 86 | 30:1 |
| Ref. 1 + 0.015% PEG (MW 400) | 3 (20.7 kPa) | 5697 | 70 | |
| | 4 (27.6 kPa) | | 104 | |
| | 5 (34.5 kPa) | | 176 | 32:1 |

However, the polishing composition having both first and second additives Maltitol and Tween® 20 (Ref. 1 + 0.025% Tween 20) provided the best performance.

While looking at oxide film and SiN removal rate changes vs the applied down forces of 3psi (20.7 kPa), 4psi (27.6 kPa) to 5psi (34.5 kPa) DF, the polishing composition having both first and second additives Maltitol and Tween® 20 not only afforded high oxide removal rate at 3.0psi (20.7 kPa) DF, but also showed very effective SiN removal rate suppressing at all applied higher DF.

In addition, the highest oxide: SiN selectivity at 3.0psi (20.7 kPa) DF vs 5.0psi (34.5 kPa) DF at about 55:1 was achieved.

**Example 2**

In Example 2, the method of using down force (DF) Offset Selectivity on judging the silicon oxide: SiN selectivity to predict the patterned wafer polishing performances was tested.

DF1 for each polishing composition shown in Table 2 was measured when the targeted HDP film removal rate of 2,000Å/min. was reached.

The SiN removal rate for each polishing composition was then measured using the applied down force of DF1 plus 3.0psi (20.7 kPa).

The DF Offset Selectivity of Silicon oxide: SiN was then calculated and listed in Table 2; where DF Offset Selectivity = 2000 Å/min. / SiN RR (Å/min) at DF1+3psi (20.7 kPa).

Table 2. Down Force (DF) Offset Selectivity of Silicon oxide: SiN

| Compositions | "DF Offset Selectivity" |
|---|---|
| 0.2% Ceria-coated Silica + 0.28% Maltitol as Ref.1 | 12.8 |
| Ref.1 + 0.025% Terqitol L-64 | 18.2 |
| Ref.1 + 0.025% DABCO DC5604 | 22.5 |
| Ref.1 + 0.025% Tween 20 | 36.2 |
| Ref.1 + 0.02% Nonidit P40 Substitute | 16.1 |

(continued)

| Compositions | "DF Offset Selectivity" |
|---|---|
| Ref.1 + 0.015% PEG (MW 8000) | 20.2 |
| Ref.1 + 0.015% PEG (MW 400) | 16.0 |

As the results show in Table 2, among all tested polishing compositions the polishing composition having both first and second additives Maltitol and Tween® 20 provided the highest "DF Offset Selectivity of Silicon oxide: SiN Films", predicting a good patterned wafer performance from the second group of additives in combination with Tween® chemical additives.

The embodiments of this invention listed above, including the working examples, are exemplary of numerous embodiments that may be made of this invention within the scope of the claims.

**Claims**

1. A chemical mechanical polishing composition comprising:

   ceria-coated inorganic oxide particles;
   at least one polysorbate-type surfactant;
   at least one non-ionic organic molecule having multiple hydroxyl functional groups in the same molecule;
   water-soluble solvent; and
   optionally
   biocide; and
   optionally pH adjuster;
   wherein the composition has a pH selected from the group consisting of 3 to 10, 4 to 9, and 4.5 to 7.5.

2. The chemical mechanical polishing composition of Claim 1, wherein the ceria-coated inorganic oxide particles are selected from the group consisting of ceria-coated colloidal silica, ceria-coated alumina, ceria-coated titania, ceria-coated zirconia particles and combinations thereof; wherein the particles preferably have a concentration range selected from the group consisting of 0.01 wt.% to 20 wt.%; 0.05 wt.% to 10 wt.%, and 0.1 wt.% to 5 wt.%; and/or wherein the water-soluble solvent is selected from the group consisting of deionized (DI) water, distilled water, and alcoholic organic solvents.

3. The chemical mechanical polishing composition of Claim 1 or Claim 2, wherein
   the at least one polysorbate-type surfactant has a concentration selected from the group consisting of 0.0001 wt.% to 2.0% wt.%, 0.001 wt.% to 1.0 wt.%, and 0.002 wt.% to 0.25 wt.%; and/or
   the at least one non-ionic organic molecule having multiple hydroxyl functional groups in the same molecule has a concentration selected from the group consisting of 0.001 wt.% to 2.0% wt.%, 0.0025 wt.% to 1.0 wt.%, and 0.05 wt.% to 0.5 wt.%.

4. The chemical mechanical polishing composition of any one of the preceding claims, wherein the at least one polysorbate-type surfactant is selected from the group consisting of polyoxyethylenesorbitan monolaurate, polyoxyethylenesorbitan monopalmitate, polyoxyethylene sorbitan monostearate, polyoxyethylenesorbitan tristearate, polyoxyethylenesorbitan monooleate, polyoxyethylenesorbitan trioleate, and combinations thereof.

5. The chemical mechanical polishing composition of any one of the preceding claims, wherein
   the non-ionic organic molecule with multiple hydroxyl functional groups in the same molecule has a general molecular structure selected from the group consisting of:

(a)

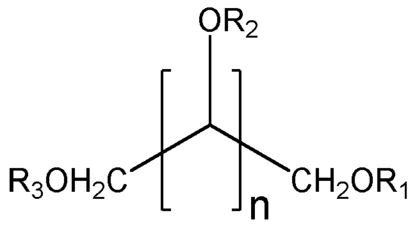

wherein

n is selected from the group consisting of 2 to 5,000, 3 to 12, and 4 to 6;
$R_1$, $R_2$, and $R_3$ groups can be the same or different atoms or functional groups and are independently selected from the group consisting of hydrogen; an alkyl group $C_mH_{2m+1}$, wherein m is selected from the group consisting of from 1 to 12, 1 to 6, and or 1 to 3; alkoxy; organic group with one or more hydroxyl groups; optionally substituted organic sulfonic acid; optionally substituted organic sulfonic acid salt; optionally substituted organic carboxylic acid; optionally substituted organic carboxylic acid salt; organic carboxylic ester; organic amine groups; and combinations thereof; and

at least two of $R_1$, $R_2$, and $R_3$ are hydrogen atoms;

(b)

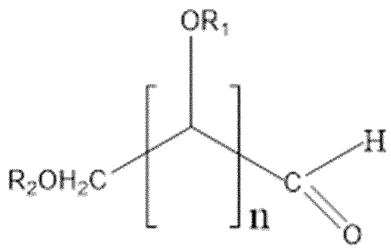

wherein

n is selected from the group consisting of 2 to 5,000, 3 to 12, and 4 to 7; and
each of $R_1$ and $R_2$ can be independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine groups, and combinations thereof; and

at least two of $R_1$ and $R_2$ are hydrogen atoms;

(c)

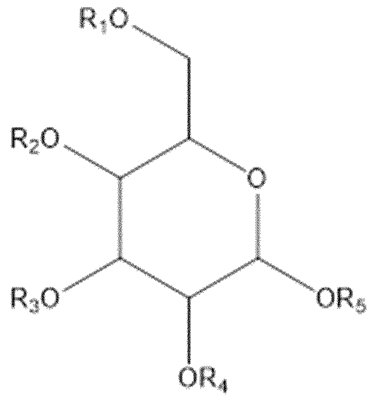

wherein
$R_1$, $R_2$, $R_3$, $R_4$, and $R_5$ are each independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine group, and combinations thereof; and
at least two of $R_1$, $R_2$, $R_3$, $R_4$, and $R_5$ are hydrogen atoms;

(d)

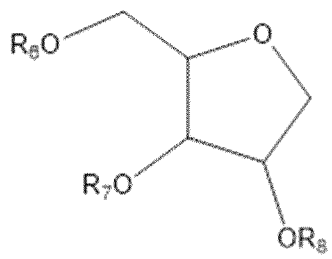

wherein
$R_6$, $R_7$, and $R_8$ are each independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine group, and combinations thereof; and
at least two of $R_6$, $R_7$, and $R_8$ are hydrogen atoms;

(e)

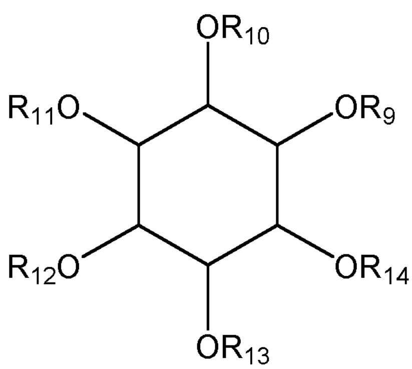

wherein

$R_9$, $R_{10}$, $R_{11}$, $R_{12}$, $R_{13}$ and $R_{14}$ are each independently selected from the group consisting of hydrogen, alkyl, alkoxy, organic group with one or more hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine group, and combinations thereof; and at least two of $R_9$, $R_{10}$, $R_{11}$, $R_{12}$, $R_{13}$ and $R_{14}$ are hydrogen atoms;

(f)

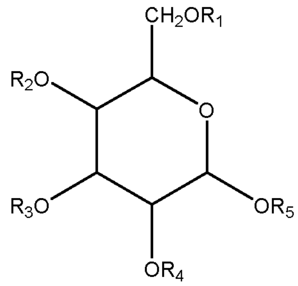

wherein
at least two of $R_1$ to $R_5$ are hydrogen atoms;
at least one of $R_1$ to $R_5$ is a polyol molecular unit having a structure shown in (i):

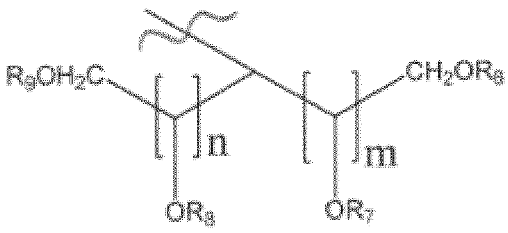

(i),

wherein

m or n are independently selected from the group consisting of 1 to 5, 1 to 4, 1 to 3, and 1 to 2;
each of $R_6$, $R_7$, $R_8$, and $R_9$ is independently selected from the group consisting of hydrogen, alkyl, alkoxy, organic group with at least one hydroxyl groups, optionally substituted organic sulfonic acid, optionally substituted organic sulfonic acid salt, optionally substituted organic carboxylic acid, optionally substituted organic carboxylic acid salt, organic carboxylic ester, organic amine, and combinations thereof; and
at least two of $R_6$, $R_7$, $R_8$, and $R_9$ are hydrogen atoms;

and
the rest of $R_1$ to $R_5$ in (f) are independently selected from the group consisting of hydrogen, alkyl, alkoxy, organic group with at least one hydroxyl group, optionally substituted organic sulfonic acid or salt, optionally substituted organic carboxylic acid or salt, organic carboxylic ester, organic amine, and a six-member ring polyol having a structure shown in (ii):

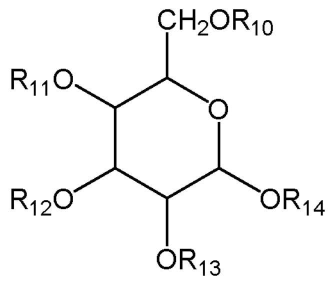

(ii)

wherein

the structure (ii) is connected through an oxygen-carbon bond to structure (f) by removing one of $R_{11}$ to $R_{14}$ in (ii); the rest of $R_{10}$ to $R_{14}$ are independently selected from the group consisting of hydrogen, alkyl, alkoxy, organic group with at least one hydroxyl group, optionally substituted organic sulfonic acid or salt, optionally substituted organic carboxylic acid or salt, organic carboxylic ester, organic amine, and combinations thereof;

and combinations thereof.

**6.** The chemical mechanical polishing composition of any one of the preceding claims, wherein the organic molecules with multiple hydroxyl functional groups in the same molecule is selected from the group consisting of maltitol, lactitol, maltotritol, ribitol, D-sorbitol, mannitol, dulcitol, iditol, D-(-)-Fructose, sorbitan, sucrose, ribose, Inositol, glucose, D-arabinose, L-arabinose, D-mannose, L-mannose, meso-erythritol, beta-lactose, arabinose, and combinations thereof.

**7.** The chemical mechanical polishing composition of any one of the preceding claims, wherein the composition comprises ceria-coated colloidal silica particles; a polysorbate-type surfactant selected from the group consisting of polyoxyethylenesorbitan monolaurate, polyoxyethylenesorbitan monopalmitate, polyoxyethylene sorbitan monostearate, polyoxyethylenesorbitan tristearate, polyoxyethylenesorbitan monooleate, polyoxyethylenesorbitan trioleate, and combinations thereof; an organic molecule with multiple hydroxyl functional groups in the same molecule selected from the group consisting of D-sorbitol, Dulcitol, Maltitol, Lactitol, and combinations thereof, and water.

**8.** The chemical mechanical polishing composition of any one of the preceding claims, wherein the composition comprises at least one of
a biocide having active ingredients of 5-chloro-2-methyl-4-isothiazolin-3-one and/or 2-methyl-4-isothiazolin-3-one; and
a pH adjusting agent selected from the group consisting of nitric acid, hydrochloric acid, sulfuric acid, phosphoric acid, other inorganic or organic acids, and mixtures thereof for acidic pH conditions; or selected from the group consisting of sodium hydride, potassium hydroxide, ammonium hydroxide, tetraalkyl ammonium hydroxide, organic quaternary ammonium hydroxide compounds, organic amines, and combinations thereof for alkaline pH conditions.

**9.** A method of chemical mechanical polishing (CMP) a semiconductor substrate having at least one surface comprising silicon oxide film, comprising

(1) providing the semiconductor substrate;
(2) providing a polishing pad;
(3) providing the chemical mechanical polishing (CMP) composition of any one of the preceding claims
(4) contacting the surface of the semiconductor substrate with the polishing pad and the chemical mechanical polishing composition; and
(5) polishing the least one surface comprising silicon dioxide;

wherein the silicon oxide film is selected from the group consisting of Chemical vapor deposition (CVD), Plasma Enhanced CVD (PECVD), High Density Deposition CVD (HDP), or spin on silicon oxide film.

**10.** The method of claim 9; wherein

the chemical mechanical polishing (CMP) composition comprises ceria-coated colloidal silica particles; the polysorbate-type surfactant is selected from the group consisting of polyoxyethylenesorbitan monolaurate, polyoxyethylenesorbitan monopalmitate, polyoxyethylene sorbitan monostearate, polyoxyethylenesorbitan tristearate, polyoxyethylenesorbitan monooleate, polyoxyethylenesorbitan trioleate, and combinations thereof; the organic molecule with multiple hydroxyl functional groups in the same molecule is selected from the group consisting of D-sorbitol, Dulcitol, Maltitol, Lactitol, and combinations thereof; and water; and
the silicon oxide film is $SiO_2$ film.

**11.** The method of claim 9 or claim 10; wherein the semiconductor substrate further comprises a silicon nitride surface; and removal selectivity of silicon oxide: silicon nitride is greater than one selected from the group consisting of 30, 40 and 50.

**12.** A system of chemical mechanical polishing (CMP) a semiconductor substrate having at least one surface comprising silicon oxide film, comprising

a. the semiconductor substrate;
b. a chemical mechanical polishing (CMP) composition as claimed in any one of Claims 1 to 8;
c. a polishing pad;
wherein
the silicon oxide film is selected from the group consisting of Chemical vapor deposition (CVD), Plasma Enhanced CVD (PECVD), High Density Deposition CVD (HDP), or spin on silicon oxide film; and
the at least one surface comprising silicon oxide film is in contact with the polishing pad and the chemical mechanical polishing composition.

**13.** The system of claim 12; wherein
the chemical mechanical polishing (CMP) composition comprises ceria-coated colloidal silica particles; the polysorbate-type surfactant is selected from the group consisting of polyoxyethylenesorbitan monolaurate, polyoxyethylenesorbitan monopalmitate, polyoxyethylene sorbitan monostearate, polyoxyethylenesorbitan tristearate, polyoxyethylenesorbitan monooleate, polyoxyethylenesorbitan trioleate, and combinations thereof; the organic molecule with multiple hydroxyl functional groups in the same molecule is selected from the group consisting of D-sorbitol, Dulcitol, Maltitol, Lactitol, and combinations thereof; and water; and
the silicon oxide film is $SiO_2$ film.

**14.** The system of claim 12 or claim 13, wherein the semiconductor substrate further comprises a silicon nitride surface; and removal selectivity of silicon oxide: silicon nitride is greater than one selected from the group consisting of 30, 40 and 50.

## Patentansprüche

**1.** Chemisch-mechanische Polierzusammensetzung, die Folgendes umfasst:

mit Cerdioxid beschichtete anorganische Oxidpartikel;
wenigstens ein Tensid vom Polysorbat-Typ;
wenigstens ein nichtionisches organisches Molekül, das mehrere funktionelle Hydroxylgruppen in demselben Molekül aufweist;
wasserlösliches Lösungsmittel; und
optional
Biozid; und
optional pH-Wert-Einsteller;
wobei die Zusammensetzung einen pH-Wert aufweist, der aus der Gruppe ausgewählt ist, die aus 3 bis 10, 4 bis 9 und 4,5 bis 7,5 besteht.

**2.** Chemisch-mechanische Polierzusammensetzung nach Anspruch 1, wobei die mit Cerdioxid beschichteten anorganischen Oxidpartikel aus der Gruppe ausgewählt sind, die aus mit Cerdioxid beschichtetem kolloidalem Siliciumdioxid, mit Cerdioxid beschichtetem Aluminiumoxid, mit Cerdioxid beschichtetem Titandioxid, mit Cerdioxid beschichteten Zirconiumdioxidpartikeln und Kombinationen davon bestehen; wobei die Partikel bevorzugt einen Konzentrationsbereich aufweisen, der aus der Gruppe ausgewählt ist, die aus 0,01 Gew.-% bis 20 Gew.-%; 0,05 Gew.%

bis 10 Gew.% und 0,1 Gew.% bis 5 Gew.% besteht; und/oder
wobei das wasserlösliche Lösungsmittel aus der Gruppe ausgewählt ist, die aus deionisiertem (DI) Wasser, destilliertem Wasser und alkoholischen organischen Lösungsmitteln besteht.

**3.** Chemisch-mechanische Polierzusammensetzung nach Anspruch 1 oder 2, wobei
das wenigstens eine Tensid vom Polysorbat-Typ eine Konzentration aufweist, das aus der Gruppe ausgewählt ist, die aus 0,0001 Gew.% bis 2,0 Gew.%, 0,001 Gew.% bis 1,0 Gew.% und 0,002 Gew.% bis 0,25 Gew.% besteht; und/oder
das wenigstens eine nichtionische organische Molekül, das mehrere funktionelle Hydroxylgruppen in demselben Molekül aufweist, eine Konzentration aufweist, die aus der Gruppe ausgewählt ist, die aus 0,001 Gew.-% bis 2,0 Gew.-%, 0,0025 Gew.-% bis 1,0 Gew.-% und 0,05 Gew.% bis 0,5 Gew.% besteht.

**4.** Chemisch-mechanische Polierzusammensetzung nach einem der vorhergehenden Ansprüche, wobei das wenigstens eine Tensid vom Polysorbat-Typ aus der Gruppe ausgewählt ist, die aus Polyoxyethylensorbitanmonolaurat, Polyoxyethylensorbitanmonopalmitat, Polyoxyethylensorbitanmonostearat, Polyoxyethylensorbitantristearat, Polyoxyethylensorbitanmonooleat, Polyoxyethylensorbitantrioleat und Kombinationen davon besteht.

**5.** Chemisch-mechanische Polierzusammensetzung nach einem der vorhergehenden Ansprüche, wobei
das nichtionische organische Molekül mit mehreren funktionellen Hydroxylgruppen in demselben Molekül eine allgemeine Molekülstruktur aufweist, die aus der Gruppe ausgewählt ist, die aus Folgendem besteht:

(a)

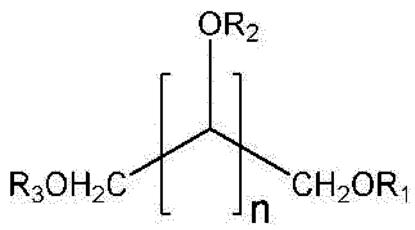

wobei

n aus der Gruppe ausgewählt ist, die aus 2 bis 5.000, 3 bis 12 und 4 bis 6 besteht;
$R_1$, $R_2$ und $R_3$ Gruppen gleiche oder verschiedene Atome oder funktionelle Gruppen sein können und unabhängig aus der Gruppe ausgewählt sind, die aus Wasserstoff; einer Alkylgruppe $C_mH_{2m+1}$, wobei m aus der Gruppe ausgewählt ist, die aus 1 bis 12, 1 bis 6 und/oder 1 bis 3 besteht; Alkoxy; organischer Gruppe mit einer oder mehreren Hydroxylgruppen; optional substituierter organischer Sulfonsäure; optional substituiertem organischem Sulfonsäuresalz; optional substituierter organischer Carbonsäure; optional substituiertem organischem Carbonsäuresalz; organischem Carbonsäureester; organischen Amingruppen; und Kombinationen davon besteht; und

wenigstens zwei von $R_1$, $R_2$ und $R_3$ Wasserstoffatome sind;

(b)

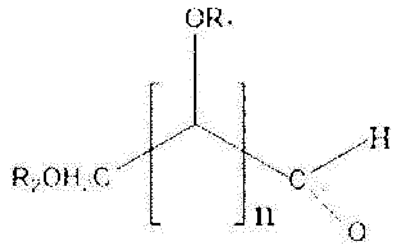

wobei n aus der Gruppe ausgewählt ist, die aus 2 bis 5.000, 3 bis 12 und 4 bis 7 besteht; und jedes von $R_1$ und $R_2$ unabhängig aus der Gruppe ausgewählt sein kann, die aus Wasserstoff, Alkyl, Alkoxy, organischer Gruppe mit einer

oder mehreren Hydroxylgruppen, optional substituierter organischer Sulfonsäure, optional substituiertem organischem Sulfonsäuresalz; optional substituierter organischer Carbonsäure; optional substituiertem organischem Carbonsäuresalz; organischem Carbonsäureester; organischen Amingruppen; und Kombinationen davon besteht; und wenigstens zwei von $R_1$ und $R_2$ Wasserstoffatome sind;

(c)

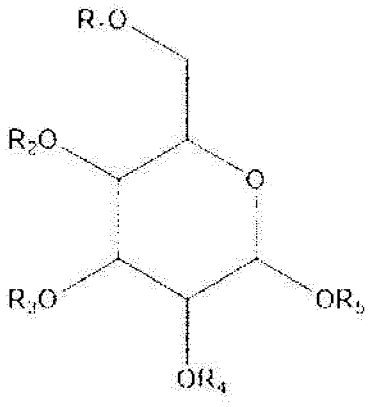

wobei
$R_1$, $R_2$, $R_3$, $R_4$ und $R_5$ jeweils unabhängig aus der Gruppe ausgewählt sind, die aus Wasserstoff, Alkyl, Alkoxy, organischer Gruppe mit einer oder mehreren Hydroxylgruppen, optional substituierter organischer Sulfonsäure, optional substituiertem organischem Sulfonsäuresalz; optional substituierter organischer Carbonsäure; optional substituiertem organischem Carbonsäuresalz; organischem Carbonsäureester; organischer Amingruppe; und Kombinationen davon besteht; und
wenigstens zwei von $R_1$, $R_2$, $R_3$, $R_4$ und $R_5$ Wasserstoffatome sind;

(d)

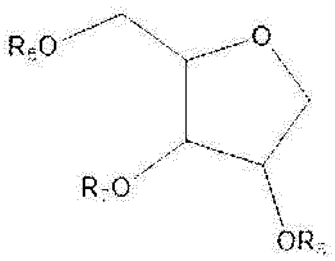

wobei
$R_6$, $R_7$ und $R_8$ jeweils unabhängig aus der Gruppe ausgewählt sind, die aus Wasserstoff, Alkyl, Alkoxy, organischer Gruppe mit einer oder mehreren Hydroxylgruppen, optional substituierter organischer Sulfonsäure, optional substituiertem organischem Sulfonsäuresalz; optional substituierter organischer Carbonsäure; optional substituiertem organischem Carbonsäuresalz; organischem Carbonsäureester; organischer Amingruppe; und Kombinationen davon besteht; und
wenigstens zwei von $R_6$, $R_7$ und $R_8$ Wasserstoffatome sind;

(e)

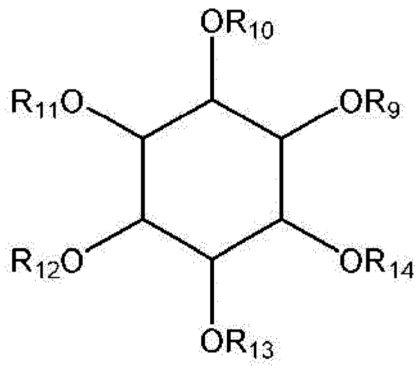

wobei
$R_9$, $R_{10}$, $R_{11}$, $R_{12}$, $R_{13}$ und $R_{14}$ jeweils unabhängig aus der Gruppe ausgewählt sind, die aus Wasserstoff, Alkyl, Alkoxy, organischer Gruppe mit einer oder mehreren Hydroxylgruppen, optional substituierter organischer Sulfonsäure, optional substituiertem organischem Sulfonsäuresalz; optional substituierter organischer Carbonsäure; optional substituiertem organischem Carbonsäuresalz; organischem Carbonsäureester; organischer Amingruppe; und Kombinationen davon besteht; und
wenigstens zwei von $R_9$, $R_{10}$, $R_{11}$, $R_{12}$, $R_{13}$ und $R_{14}$ Wasserstoffatome sind;

(f)

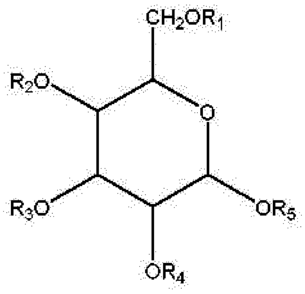

wobei
wenigstens zwei von $R_1$ bis $R_5$ Wasserstoffatome sind;
wenigstens eines von $R_1$ bis $R_5$ eine Polyol-Moleküleinheit ist, die eine in (i) gezeigte Struktur aufweist:

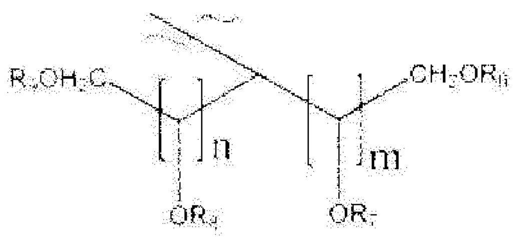

(i).

wobei

m oder n unabhängig aus der Gruppe ausgewählt sind, die aus 1 bis 5, 1 bis 4, 1 bis 3 und 1 bis 2 besteht; jedes von $R_6$, $R_7$, $R_8$ und $R_9$ unabhängig aus der Gruppe ausgewählt ist, die aus Wasserstoff, Alkyl, Alkoxy, organischer Gruppe mit wenigstens einer Hydroxylgruppen, optional substituierter organischer Sulfonsäure, optional substituiertem organischem Sulfonsäuresalz; optional substituierter organischer Carbonsäure; optional substituiertem organischem Carbonsäuresalz; organischem Carbonsäureester; organischem Amin; und Kombinationen davon besteht; und wenigstens zwei von $R_6$, $R_7$, $R_8$ und $R_9$ Wasserstoffatome sind;

und

die restlichen von $R_1$ bis $R_5$ in (f) unabhängig aus der Gruppe ausgewählt sind, die aus Wasserstoff, Alkyl, Alkoxy, organischer Gruppe mit wenigstens einer Hydroxylgruppe, optional substituierter/m organischer/m Sulfonsäure oder -salz, optional substituierter/m organischer/m Carbonsäure oder -salz, organischem Carbonsäureester, organischem Amin und einem sechsgliedrigen Ringpolyol, das eine in (ii) gezeigte Struktur aufweist, besteht:

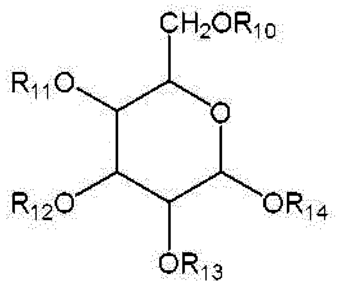

(ii)

wobei

die Struktur (ii) durch eine Sauerstoff-Kohlenstoff-Bindung mit Struktur (f) durch Entfernen von einem von $R_{11}$ bis $R_{14}$ in (ii) verbunden ist;

die restlichen von $R_{10}$ bis $R_{14}$ unabhängig aus der Gruppe ausgewählt sind, die aus Wasserstoff, Alkyl, Alkoxy, organischer Gruppe mit wenigstens einer Hydroxylgruppe, optional substituierter/m organischer/m Sulfonsäure oder -salz, optional substituierter/m organischer/m Carbonsäure oder -salz, organischem Carbonsäureester, organischem Amin und Kombinationen davon besteht;

und Kombinationen davon.

**6.** Chemisch-mechanische Polierzusammensetzung nach einem der vorhergehenden Ansprüche, wobei die organischen Moleküle mit mehreren funktionellen Hydroxylgruppen in demselben Molekül aus der Gruppe ausgewählt sind, die aus Maltit, Lactit, Maltotrit, Ribit, D-Sorbit, Mannit, Dulcit, Idit, D-(-)-Fructose, Sorbitan, Saccharose, Ribose, Inosit, Glucose, D-Arabinose, L-Arabinose, D-Mannose, L-Mannose, Mesoerythrit, Beta-Lactose, Arabinose und Kombinationen davon besteht.

**7.** Chemisch-mechanische Polierzusammensetzung nach einem der vorhergehenden Ansprüche, wobei die Zusammensetzung mit Cerdioxid beschichtete kolloidale Siliciumdioxidpartikel; ein Tensid vom Polysorbat-Typ, das aus der Gruppe ausgewählt ist, die aus Polyoxyethylensorbitanmonolaurat, Polyoxyethylensorbitanmonopalmitat, Polyoxyethylensorbitanmonostearat, Polyoxyethylensorbitantristearat, Polyoxyethylensorbitanmonooleat, Polyoxyethylensorbitantrioleat und Kombinationen davon besteht; ein organisches Molekül mit mehreren funktionellen Hydroxylgruppen in demselben Molekül, das aus der Gruppe ausgewählt ist, die aus D-Sorbit, Dulcit, Maltit, Lactit und Kombinationen davon besteht, und Wasser umfasst.

**8.** Chemisch-mechanische Polierzusammensetzung nach einem der vorhergehenden Ansprüche, wobei die Zusammensetzung Folgendes umfasst:

ein Biozid, das Wirkstoffe von 5-Chlor-2-methyl-4-isothiazolin-3-on und/oder 2-Methyl-4-isothiazolin-3-on aufweist; und/oder

ein pH-Wert-Einstellmittel, das aus der Gruppe ausgewählt ist, die aus Salpetersäure, Salzsäure, Schwefelsäure, Phosphorsäure, anderen anorganischen oder organischen Säuren und Mischungen davon für saure pH-Wert-Bedingungen besteht; oder aus der Gruppe ausgewählt ist, die aus Natriumhydrid, Kaliumhydroxid, Ammoniumhydroxid, Tetraalkylammoniumhydroxid, organischen quaternären Ammoniumhydroxidverbindungen, organischen Aminen und Kombinationen davon für alkalische pH-Wert-Bedingungen besteht.

**9.** Verfahren zum chemisch-mechanischen Polieren (CMP) eines Halbleitersubstrats, das wenigstens eine Oberfläche aufweist, die einen Siliziumoxidfilm umfasst, das Folgendes umfasst:

(1) Bereitstellen des Halbleitersubstrats;
(2) Bereitstellen eines Polierkissens;
(3) Bereitstellen der chemisch-mechanischen Polier(CMP)-Zusammensetzung nach einem der vorhergehenden Ansprüche
(4) Berühren der Oberfläche des Halbleitersubstrats mit dem Polierkissen und der chemisch-mechanischen Polierzusammensetzung; und
(5) Polieren der wenigstens einen Oberfläche, die Siliziumdioxid umfasst;

wobei der Siliziumoxidfilm aus der Gruppe ausgewählt ist, die aus chemischer Gasphasenabscheidung (Chemical vapor deposition - CVD), plasmaunterstützter CVD (Plasma Enhanced CVD - PECVD), Abscheidung mit hoher Dichte CVD (High Density Deposition CVD - HDP) oder aufgeschleudertem Siliziumoxidfilm besteht.

**10.** Verfahren nach Anspruch 9, wobei:
die chemisch-mechanische Polier(CMP)-Zusammensetzung mit Cerdioxid beschichtete kolloidale Siliciumdioxidpartikel umfasst; das Tensid vom Polysorbat-Typ aus der Gruppe ausgewählt ist, die aus Polyoxyethylensorbitanmonolaurat, Polyoxyethylensorbitanmonopalmitat, Polyoxyethylensorbitanmonostearat, Polyoxyethylensorbitantristearat, Polyoxyethylensorbitanmonooleat, Polyoxyethylensorbitantrioleat und Kombinationen davon besteht; das organische Molekül mit mehreren funktionellen Hydroxylgruppen in demselben Molekül aus der Gruppe ausgewählt ist, die aus D-Sorbit, Dulcit, Maltit, Lactit und Kombinationen davon und Wasser besteht; und der Siliziumoxidfilm $SiO_2$-Film ist.

**11.** Verfahren nach Anspruch 9 oder 10; wobei das Halbleitersubstrat ferner eine Siliziumnitridoberfläche umfasst; und Entfernungsselektivität von Siliziumoxid : Siliziumnitrid größer als eines ist, das aus der Gruppe ausgewählt ist, die aus 30, 40 und 50 besteht.

**12.** System zum chemisch-mechanischen Polieren (CMP) eines Halbleitersubstrats, das wenigstens eine Oberfläche aufweist, die einen Siliziumoxidfilm umfasst, das Folgendes umfasst:

a. das Halbleitersubstrat;
b. eine chemisch-mechanische Polier(CMP)-Zusammensetzung nach einem der Ansprüche 1 bis 8;
c. ein Polierkissen;
wobei
der Siliziumoxidfilm aus der Gruppe ausgewählt ist, die aus chemischer Gasphasenabscheidung (CVD), plasmaunterstützter CVD (PECVD), Abscheidung mit hoher Dichte CVD (HDP) oder aufgeschleudertem Siliziumoxidfilm besteht. die wenigstens eine Oberfläche, die Siliziumoxidfilm umfasst, mit dem Polierkissen und der chemisch-mechanischen Polierzusammensetzung in Berührung steht.

**13.** System nach Anspruch 12, wobei:
die chemisch-mechanische Polier(CMP)-Zusammensetzung mit Cerdioxid beschichtete kolloidale Siliciumdioxidpartikel umfasst; das Tensid vom Polysorbat-Typ aus der Gruppe ausgewählt ist, die aus Polyoxyethylensorbitanmonolaurat, Polyoxyethylensorbitanmonopalmitat, Polyoxyethylensorbitanmonostearat, Polyoxyethylensorbitantristearat, Polyoxyethylensorbitanmonooleat, Polyoxyethylensorbitantrioleat und Kombinationen davon besteht; das organische Molekül mit mehreren funktionellen Hydroxylgruppen in demselben Molekül aus der Gruppe ausgewählt ist, die aus D-Sorbit, Dulcit, Maltit, Lactit und Kombinationen davon und Wasser besteht; und der Siliziumoxidfilm $SiO_2$-Film ist.

**14.** System nach Anspruch 12 oder 13, wobei das Halbleitersubstrat ferner eine Siliziumnitridoberfläche umfasst; und Entfernungsselektivität von Siliziumoxid : Siliziumnitrid größer als eines ist, das aus der Gruppe ausgewählt ist, die aus 30, 40 und 50 besteht.

## Revendications

**1.** Composition de polissage mécano-chimique comprenant :

des particules d’oxyde inorganique enrobées de cérium ;
au moins un tensioactif de type polysorbate ;
au moins une molécule organique non ionique ayant de multiples groupements fonctionnels hydroxyle dans la

molécule identique ;
un solvant hydrosoluble ; et
éventuellement
un biocide ; et
éventuellement un ajusteur de pH ;
la composition ayant un pH sélectionné dans le groupe constitué de 3 à 10, 4 à 9 et de 4,5 à 7,5.

**2.** Composition de polissage mécano-chimique selon la revendication 1, dans laquelle les particules d'oxyde inorganique enrobées de cérium sont sélectionnées dans le groupe constitué par la silice colloïdale enrobée de céria, l'alumine enrobée de céria, le titane enrobé de céria, les particules de zircone enrobées de céria et leurs combinaisons ; les particules ayant de préférence une plage de concentration sélectionnée dans le groupe constitué de 0,01 % en poids à 20 % en poids ; 0,05 % en poids à 10 % en poids et 0,1 % en poids à 5 % en poids ; et/ou
le solvant hydrosoluble étant sélectionné dans le groupe constitué par l'eau déionisée (DI), l'eau distillée et les solvants organiques alcooliques.

**3.** Composition de polissage mécano-chimique selon la revendication 1 ou la revendication 2, dans laquelle
l'au moins un tensioactif de type polysorbate a une concentration sélectionnée dans le groupe constitué de 0,0001 % en poids à 2,0 % en poids, 0,001 % en poids à 1,0 % en poids et 0,002 % en poids à 0,25 % en poids ; et/ou
l'au moins une molécule organique non ionique ayant de multiples groupements fonctionnels hydroxyle dans la molécule identique a une concentration sélectionnée dans le groupe constitué de 0,001 % en poids à 2,0 % en poids de poids, 0,0025 % en poids à 1,0 % en poids et 0,05 % en poids à 0,5 % en poids.

**4.** Composition de polissage mécano-chimique selon l'une quelconque des revendications précédentes, dans laquelle l'au moins un tensioactif de type polysorbate est sélectionné dans le groupe constitué par le monolaurate de polyoxyéthylènesorbitane, le monopalmitate de polyoxyéthylènesorbitane, le monostéarate de polyoxyéthylène sorbitane, le tristéarate de polyoxyéthylènesorbitane, le monooléate de polyoxyéthylènesorbitane, le trioléate de polyoxyéthylènesorbitane et leurs combinaisons.

**5.** Composition de polissage mécano-chimique selon l'une quelconque des revendications précédentes, dans laquelle la molécule organique non ionique dotée de multiples groupements fonctionnels hydroxyle dans la molécule identique a une structure moléculaire générale sélectionnée dans le groupe constitué par :

**(a)**

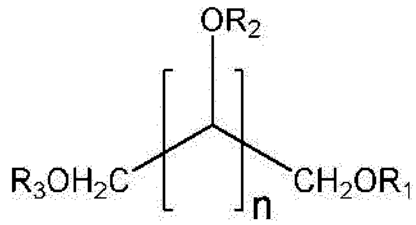

où

n est sélectionné dans le groupe constitué de 2 à 5 000, de 3 à 12 et de 4 à 6 ;
les groupes $R_1$, $R_2$ et $R_3$ peuvent être des atomes ou des groupements fonctionnels identiques ou différents et sont indépendamment sélectionnés dans le groupe constitué par l'hydrogène ; un groupe alkyle $C_mH_{2m+1}$, où m est sélectionné dans le groupe constitué de 1 à 12, 1 à 6 et/ou 1 à 3 ; l'alcoxy ; le groupe organique avec un ou plusieurs groupes hydroxyle ; l'acide sulfonique organique éventuellement substitué ; le sel d'acide sulfonique organique éventuellement substitué ; l'acide carboxylique organique éventuellement substitué ; le sel d'acide carboxylique organique éventuellement substitué ; l'ester carboxylique organique ; des groupes amine organique ; et leurs combinaisons ; et

au moins deux de $R_1$, $R_2$ et $R_3$ sont des atomes d'hydrogène ;

(b)

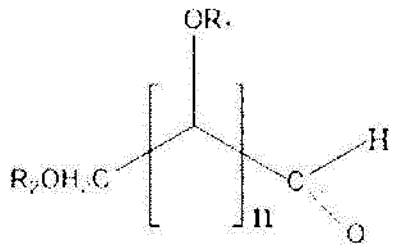

où

n est sélectionné dans le groupe constitué de 2 à 5 000, 3 à 12 et 4 à 7 ; et

chacun de $R_1$ et $R_2$ peut être indépendamment sélectionné dans le groupe constitué par l'hydrogène, l'alkyle, l'alcoxy, le groupe organique avec un ou plusieurs groupes hydroxyle, l'acide sulfonique organique éventuellement substitué, le sel d'acide sulfonique organique éventuellement substitué, l'acide carboxylique organique éventuellement substitué, le sel d'acide carboxylique organique éventuellement substitué, l'ester carboxylique organique, les groupes amine organique et leurs combinaisons ; et

au moins deux de $R_1$ et $R_2$ sont des atomes d'hydrogène ;

(c)

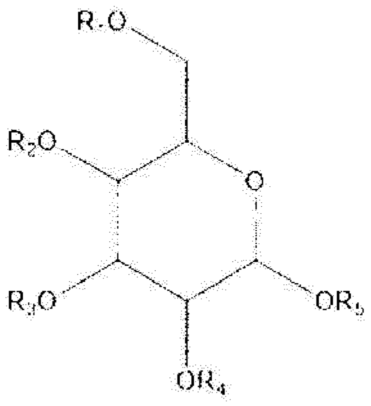

où

$R_1$, $R_2$, $R_3$, $R_4$, et $R_5$ sont chacun indépendamment sélectionnés dans le groupe constitué par l'hydrogène, l'alkyle, l'alcoxy, le groupe organique avec un ou plusieurs groupes hydroxyle, l'acide sulfonique organique éventuellement substitué, le sel d'acide sulfonique organique éventuellement substitué, l'acide carboxylique organique éventuellement substitué, le sel d'acide carboxylique organique éventuellement substitué, l'ester carboxylique organique, le groupes amine organique et leurs combinaisons ; et

au moins deux de $R_1$, $R_2$, $R_3$, $R_4$, et $R_5$ sont des atomes d'hydrogène ;

(d)

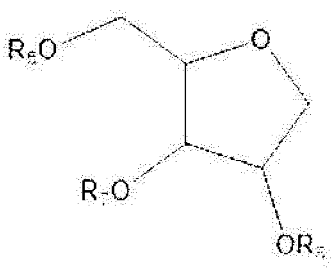

où

$R_6$, $R_7$, et $R_8$ sont chacun indépendamment sélectionnés dans le groupe constitué par l'hydrogène, l'hydrogène, l'alkyle, l'alcoxy, le groupe organique avec un ou plusieurs groupes hydroxyle, l'acide sulfonique organique éventuellement substitué, le sel d'acide sulfonique organique éventuellement substitué, l'acide carboxylique organique éventuellement substitué, le sel d'acide carboxylique organique éventuellement substitué, l'ester carboxylique organique, le groupes amine organique et leurs combinaisons ; et
au moins deux de $R_6$, $R_7$ et $R_8$ sont des atomes d'hydrogène ;

(e)

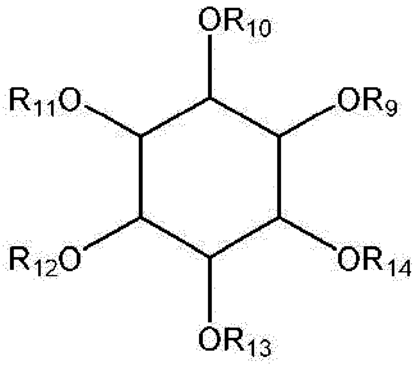

où
$R_9$, $R_{10}$, $R_{11}$, $R_{12}$, $R_{13}$ et $R_{14}$ sont chacun indépendamment sélectionnés dans le groupe constitué par l'hydrogène, l'alkyle, l'alcoxy, le groupe organique avec un ou plusieurs groupes hydroxyle, l'acide sulfonique organique éventuellement substitué, le sel d'acide sulfonique organique éventuellement substitué, l'acide carboxylique organique éventuellement substitué, le sel d'acide carboxylique organique éventuellement substitué, l'ester carboxylique organique, le groupes amine organique et leurs combinaisons ; et
au moins deux de $R_9$, $R_{10}$, $R_{11}$, $R_{12}$, $R_{13}$ et $R_{14}$ sont des atomes d'hydrogène ;

(f)

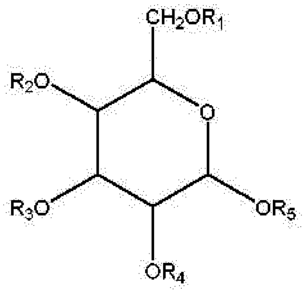

où
au moins deux de $R_1$ à $R_5$ sont des atomes d'hydrogène ;
au moins l'un de $R_1$ à $R_5$ est une unité moléculaire de polyol ayant une structure représentée dans (i) :

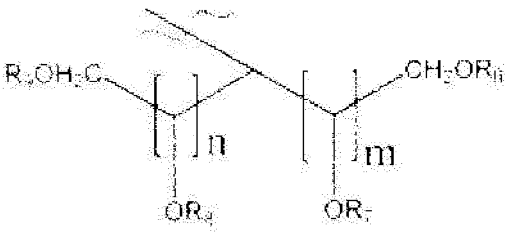

(i).

où

m ou n sont indépendamment sélectionnés dans le groupe constitué de 1 à 5, 1 à 4, 1 à 3 et 1 à 2 ;
chacun de $R_6$, $R_7$, $R_8$, et $R_9$ est indépendamment sélectionné dans le groupe constitué par l'hydrogène, l'alkyle, l'alcoxy, le groupe organique avec au moins un groupe hydroxyle, l'acide sulfonique organique éventuellement substitué, le sel d'acide sulfonique organique éventuellement substitué, l'acide carboxylique organique éventuellement substitué, le sel d'acide carboxylique organique éventuellement substitué, l'ester carboxylique organique, l'amine organique et leurs combinaisons ; et au moins deux de $R_6$, $R_7$, $R_8$, et $R_9$ sont des atomes d'hydrogène ;

et
le reste de $R_1$ à $R_5$ dans (f) sont indépendamment sélectionnés dans le groupe constitué par l'hydrogène, l'alkyle, l'alcoxy, le groupe organique avec au moins un groupe hydroxyle, le sel ou l'acide sulfonique organique éventuellement substitué, le sel ou l'acide carboxylique organique éventuellement substitué, l'ester carboxylique organique, l'amine organique et le polyol en cycle à six chaînons ayant une structure représentée dans (ii) :

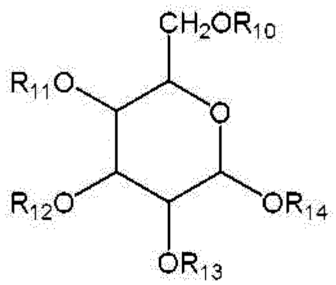

(ii)

où

la structure (ii) est reliée par une liaison oxygène-carbone à la structure (f) en éliminant l'un de $R_{11}$ à $R_{14}$ dans (ii) ;
le reste de $R_{10}$ à $R_{14}$ étant indépendamment sélectionnés dans le groupe constitué par l'hydrogène, l'alkyle, l'alcoxy, le groupe organique avec au moins un groupe hydroxyle, le sel ou l'acide sulfonique organique éventuellement substitué, le sel ou l'acide carboxylique organique éventuellement substitué, l'ester carboxylique organique, l'amine organique et leurs combinaisons ;
et leurs combinaisons.

**6.** Composition de polissage mécano-chimique selon l'une quelconque des revendications précédentes, dans laquelle les molécules organiques dotées de multiples groupements fonctionnels hydroxyle dans la molécule identique sont sélectionnées dans le groupe constitué par le maltitol, le lactitol, le maltotritol, le ribitol, le D-sorbitol, le mannitol, le dulcitol, l'iditol, le D-(-)-fructose, le sorbitan, le saccharose, le ribose, l'inositol, le glucose, le D-arabinose, le L-arabinose, le D-mannose, le L-mannose, le méso-érythritol, le bêta-lactose, l'arabinose et leurs combinaisons.

**7.** Composition de polissage mécano-chimique selon l'une quelconque des revendications précédentes, dans laquelle la composition comprend des particules de silice colloïdale enrobées de cérium ; un tensioactif de type polysorbate sélectionné dans le groupe constitué par le monolaurate de polyoxyéthylènesorbitane, le monopalmitate de polyoxyéthylènesorbitane, le monostéarate de polyoxyéthylène sorbitane, le tristéarate de polyoxyéthylènesorbitane, le monooléate de polyoxyéthylènesorbitane, le trioléate de polyoxyéthylènesorbitane et leurs combinaisons ; une molécule organique dotée de multiples groupements fonctionnels hydroxyle dans la molécule identique sélectionnée dans le groupe constitué par le D-sorbitol, le dulcitol, le maltitol, le lactitol, et leurs combinaisons, et de l'eau.

**8.** Composition de polissage mécano-chimique selon l'une quelconque des revendications précédentes, dans laquelle la composition comprend au moins l'un parmi
un biocide ayant des ingrédients actifs de 5-chloro-2-méthyl-4-isothiazolin-3-one et/ou 2-méthyl-4-isothiazolin-3-one ; et
un agent d'ajustement du pH sélectionné dans le groupe constitué par l'acide nitrique, l'acide chlorhydrique, l'acide sulfurique, l'acide phosphorique, d'autres acides inorganiques ou organiques, et leurs mélanges pour des conditions de pH acide ; ou sélectionné dans le groupe constitué par l'hydrure de sodium, l'hydroxyde de potassium, l'hydroxyde d'ammonium, l'hydroxyde de tétraalkylammonium, les composés de l'hydroxyde d'ammonium quaternaire organique, les amines organiques et leurs combinaisons pour les conditions de pH alcalin.

9. Procédé de polissage mécano-chimique (CMP) d'un substrat semi-conducteur ayant au moins une surface comprenant un film d'oxyde de silicium, comprenant

(1) la fourniture du substrat semi-conducteur ;
(2) la fourniture d'un tampon de polissage ;
(3) la fourniture de la composition de polissage mécano-chimique (CMP) selon l'une quelconque des revendications précédentes
(4) la mise en contact de la surface du substrat semi-conducteur avec le tampon de polissage et la composition de polissage mécano-chimique ; et
(5) le polissage de l'au moins une surface comprenant du dioxyde de silicium ;

le film d'oxyde de silicium étant sélectionné dans le groupe constitué par le dépôt chimique en phase vapeur (CVD), le CVD assisté par plasma (PECVD), le CVD par dépôt à haute densité (HDP), ou la centrifugation sur film d'oxyde de silicium.

10. Procédé selon la revendication 9, dans lequel
la composition de polissage mécano-chimique (CMP) comprend des particules de silice colloïdale enrobée de cérium ; le tensioactif de type polysorbate est sélectionné dans le groupe constitué par le monolaurate de polyoxyéthylènesorbitane, le monopalmitate de polyoxyéthylènesorbitane, le monostéarate de polyoxyéthylènesorbitane, le tristéarate de polyoxyéthylènesorbitane, le monooléate de polyoxyéthylènesorbitane, le trioléate de polyoxyéthylènesorbitane, et leurs combinaisons ; la molécule organique dotée de multiples groupements fonctionnels hydroxyle dans la molécule identique est sélectionnée dans le groupe constitué par le D-sorbitol, le dulcitol, le maltitol, le lactitol, et leurs combinaisons ; et de l'eau ; et
le film d'oxyde de silicium est un film de $SiO_2$.

11. Procédé selon la revendication 9 ou la revendication 10 ; dans lequel le substrat semi-conducteur comprend en outre une surface en nitrure de silicium ; et une sélectivité pour l'élimination de l'oxyde de silicium : le nitrure de silicium étant supérieur à celui sélectionné dans le groupe constitué de 30, 40 et 50.

12. Système de polissage mécano-chimique (CMP) d'un substrat semi-conducteur ayant au moins une surface comprenant un film d'oxyde de silicium, comprenant

a. le substrat semi-conducteur ;
b. une composition de polissage mécano-chimique (CMP) selon l'une quelconque des revendications 1 à 8 ;
c. un tampon de polissage ;

dans lequel
le film d'oxyde de silicium est sélectionné dans le groupe constitué par le dépôt chimique en phase vapeur (CVD), le CVD assisté par plasma (PECVD), le CVD par dépôt à haute densité (HDP), ou la centrifugation sur film d'oxyde de silicium ; et
l'au moins une surface comprenant un film d'oxyde de silicium est en contact avec le tampon de polissage et la composition de polissage mécano-chimique.

13. Système selon la revendication 12, dans lequel :
la composition de polissage mécano-chimique (CMP) comprend des particules de silice colloïdale enrobée de cérium ; le tensioactif de type polysorbate est sélectionné dans le groupe constitué par le monolaurate de polyoxyéthylènesorbitane, le monopalmitate de polyoxyéthylènesorbitane, le monostéarate de polyoxyéthylènesorbitane, le tristéarate de polyoxyéthylènesorbitane, le monooléate de polyoxyéthylènesorbitane, le trioléate de polyoxyéthylènesorbitane, et leurs combinaisons ; la molécule organique dotée de multiples groupements fonctionnels hydroxyle dans la molécule identique est sélectionnée dans le groupe constitué par le D-sorbitol, le dulcitol, le maltitol, le lactitol, et leurs combinaisons ; et de l'eau ; et le film d'oxyde de silicium est un film de $SiO_2$.

14. Système selon la revendication 12 ou 13, dans lequel le substrat semi-conducteur comprend en outre une surface en nitrure de silicium ; et la sélectivité pour l'élimination de l'oxyde de silicium : le nitrure de silicium étant supérieur à celui sélectionné dans le groupe constitué de 30, 40 et 50.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 5876490 A
- US 6964923 B
- US 6616514 B
- US 6984588 B
- US 6544892 B
- US 7247082 B
- US 8778203 B
- US 6914001 B
- WO 03101665 A1